# EUROPEAN PATENT APPLICATION

(11) **EP 0 919 602 A1**
(43) Date of publication of application: **02.06.1999**
(21) Application number: 98122108.8
(22) Date of filing: 23.11.1998
(51) Int. Cl.: C09G 1/02, C23F 3/00, H01L 21/321

(54) **Metal polishing agent and process for polishing metal using same**

(30) Priority: 25.11.1997 JP 322904/97
(71) Applicant: Sumitomo Chemical Company, Limited, Chuo-ku Osaka 541-8550 (JP)
(72) Inventor: Takashima, Masayuki, Sodegaura-shi, Chiba (JP); Sawara, Kenichi, Ichihara-shi, Chiba (JP); Sukumoda, Atsushi, Sodegaura-shi, Chiba (JP)
(74) Representative: VOSSIUS & PARTNER

(57) **Abstract**

There is provided a metal polishing agent comprising an aqueous emulsion comprising a complexing agent capable of reacting with a metal to form a water soluble metal complex and a resin particle prepared by emulsion polymerization of a vinyl compound, which is particularly useful for polishing a metal film formed on a silicon wafer by a chemical and mechanical polishing.

## Description

The present invention relates to a metal polishing agent useful in the production of semiconductor devices and a process for polishing a metal using the same. More specifically, the present invention relates to a metal polishing agent useful for polishing a metal film formed on a silicon wafer by chemical mechanical polishing and a process for polishing the metal film using the same.

Various micro-processing techniques have been studied and developed to accomplish larger integration scales and higher performances of large-scale integrated circuits ( LSIs ). Among them, chemical mechanical polishing (hereinafter referred to "CMP") has become of major interest lately. The CMP performs both of a chemical action between a polishing agent and a material to be polished and a mechanical action of polishing particles contained in the polishing agent, and now becomes essential particularly for planarization of insulating interlayers in the formation of multilayer wiring and formation of metal plugs and buried metal wiring.

From the viewpoint of speeding up of LSIs in the feature, aluminum(Al), copper(Cu) and other metals having a low resistance will be mainly used as metals for the metal wiring, and therefore, the formation of metal plugs and buried wiring using such metals has been studied extensively.

For the CMP of such metal films, a polishing slurry comprising inorganic particles such as alumina and silica and an oxidizing agent such as ferric nitrate and hydrogen peroxide has become a principal subject of study.

However, the metal such as Al and Cu are low in hardness, and therefore, when polished with the inorganic particles of high hardness such as alumina and silica, the surface of the metal film is damaged and made rough, and moreover the polishing particles are buried in the wiring metal film.

Meanwhile, there is known a dishing, which is a phenomenon such that, at a region where the wiring metal film buried in trenches and openings is widened, the central portion of the metal film becomes thin. In general, polishing particles tend to stay behind at that thin portion. Such tendency is remarkable when metals having low hardness such as Al and Cu are used as the wiring metal film.

The damaged surface of the wiring metal film, the dishing and the staying of polishing particles increase the wire resistance and bring about disconnection of the wire, resulting in decrease of reliability and product yield.

In order to remedy the deficiencies, JP-A-07-086216 proposes to use particles containing an organic high molecular weight compound as a major component for the polishing particles. According to the patent, polishing particles of organic high molecular weight compounds such as methacryl resins including PMMA, phenol resins, melamine resins, polystyrene resins and polycarbonate resins, or carbon black are dispersed in water along with a dispersant to prepare a polishing slurry, which is then used for the polishing, whereby the surface of metal film can be prevented from damaging, and the polishing stability can be improved.

However, the process requires a step of preparing the polishing slurry by dispersing the polishing particles in water along with a dispersant. Therefore, the dispersion property of the particles and the dispersion stability may vary widely in each step of preparing the polishing slurry, and moreover it is difficult to control the particle size of the polishing particles arbitrarily. Furthermore, the polishing speed required in a practical polishing process for the production of semiconductor devices is said to be more than 2000Å/min. On the other hand, the document discloses in the Examples that the polishing speed is 200Å/min. to 900Å/min., which is too slow to use the method in the practical production of semiconductor devices.

An object of the present invention is to provide a polishing agent useful for the production of semiconductor devices, and capable of being prepared without the step of dispersing polishing particles in water, which agent exhibits a stable polishing performance and a sufficient polishing speed required for the practical production of semiconductor devices, and gives a polished product free from any damages and remaining polishing particles on its surface.

The present invention provides a metal polishing agent, more specifically a polishing agent useful for polishing a metal film formed on a silicon wafer, which comprises an aqueous emulsion comprising a complexing agent capable of reacting with a metal to be polished to form a water soluble metal complex and resin particles prepared by emulsion polymerization of a vinyl compound.

The present invention also provides a process for producing the polishing agent, which comprises steps of emulsion-polymerizing a vinyl compound to obtain an aqueous emulsion, and mixing the aqueous emulsion with a complexing agent capable of reacting with a metal to be polished to form a water soluble metal complex.

The present invention further provides a process for polishing a metal, more specifically a process for polishing a metal film formed on a silicon wafer, which comprises polishing the metal by the CMP with the polishing agent.

The present invention is illustrated in detail as follows.

The polishing agent of the present invention is useful for polishing a metal, more specifically a metal film formed on a silicon wafer by the CMP.

Examples of the metal used for forming the metal film are aluminum (Al), copper (Cu) and tungsten (W).

Examples of the metal film to be polished are an aluminum film and a film of an alloy containing aluminum as an essential component such as AlSiCu alloy and AlCu alloy.

Examples of the complexing agent capable of reacting with the metal to form a water soluble complex are ammonium fluoride, acetylacetone, citric acid, tartaric acid, glycine, catechol, lysine and 2-aminoethanesulfonic acid. Of these, ammonium fluoride, acetylacetone and glycine are particularly preferred, because ammonium fluoride can produce results of improving the polishing speed for an Al film, and acetylacetone and glycine can produce similar results for a Cu film.

Although the concentration of the complexing agent in the polishing agent is not particularly limited, it is preferred to adjust the concentration within a range of from 0.5% to 10% by weight based on the weight of the polishing agent, whereby a polishing speed of more than 2000Å/min. can be attained. When the concentration is too low, a satisfactory polishing speed can hardly be obtained, while when the concentration is too high, the polishing speed may become too high to be controlled arbitrarily.

The vinyl compound used for the emulsion polymerization to form the desired resin particles includes, for example, aromatic vinyl compounds such as styrene, vinyltoluene ,divinylbenzene, and α-methylstyrene; conjugated diene compounds such as butadiene and isoprene; vinyl halides such as vinyl chloride and vinylidene chloride; ethylene; vinyl esters such as vinyl acetate, vinyl propionate, vinyl pivalate, vinyl laurate and vinyl versatate; C₁₋₁₈ alkyl esters of (meth)acrylic acids such as methyl (meth)acrylate, ethyl (meth)acrylate, butyl (meth)acrylate, 2-ethylhexyl (meth)acrylate, lauryl (meth)acrylate and stearyl (meth)acrylate; α,β-ethylenically unsaturated carboxylic acid esters such as maleic ester, fumaric ester and itaconic ester; and (meth)acrylonitrile. These vinyl compounds can be polymerized singly or in a mixture of two or more to form a copolymer.

If desired, it is possible to use other vinyl compounds including, for example, functional vinyl compounds having an amide group, hydroxyl group, methoxy group or glycidyl group, α,β-unsaturated bond-carrying compounds and polyfunctional compounds such as poly(meth)acrylates.

These above-mentioned vinyl compounds are hereinafter referred to a "monomer".

The emulsion polymerization can be carried out in an aqueous medium in any known manner. For example, the polymerization can be carried out by adding the whole amount of the monomer at an initial stage or by adding the monomer dividedly or continuously. A polymerization initiator may be added also in any manner.

Emulsifiers used for the emulsion polymerization includes those used conventionally, for example, water soluble polymers and cationic, anionic, nonionic and amphoteric surfactants. Alternatively, the polymerization may be carried out in the absence of an emulsifier, i.e. in a manner of a so-called soap-free emulsion polymerization.

As a polymerization initiator used, any compound may be used as far as it is capable of generating free radicals. Examples thereof are potassium persulfate, sodium persulfate, ammonium persulfate, 2,2-azobis(2-amidinopropane)hydrochloride and redox initiators formed by combining the above-mentioned oxidizing compounds with reducing compounds such as L- or D-ascorbic acid, sulfites, rongalite and ferrous sulfate.

A concentration of the polymerization initiator is not less than 0.05% by weight based on the weight of the monomer. Too low a concentration deteriorates stability of the resin particle.

Considering the fact that the polishing agent in accordance with the present invention is particularly useful for the production of semiconductor devices, the materials to be added in the polymerization system such as the polymerization initiator are preferably those other than metal salts.

The polymerization can be carried out at a temperature of usually from 30°C to 100°C, preferably from 40°C to 80°C.

As a result of the emulsion polymerization, an aqueous emulsion containing spherical resin particles can be obtained as the reaction product.

The particle size and its distribution of the resin particle can be controlled arbitrarily by controlling the concentration of the polymerization initiator, the monomer composition, the manner of adding the monomer and operational conditions such as stirring condition.

In the present invention, it is preferred to adjust the average particle size of the resin particle within a range of from about 0.05 µ m to about 0.5 µ m. When the average particle size is too small, the particles may aggregate to damage the metal to be polished. On the other hand, when the average particle size is too large, the metal to be polished may be damaged and the dishing may be increased, and moreover the polishing agent may become unsuitable for a long term storage, because the polishing particles in the metal polishing agent may precipitate easily.

The concentration of the resin particles in the metal polishing agent is preferably from 0.5% to 20% by weight based on the weight of the metal polishing agent. Too low a concentration may result in insufficient polishing speed, whereas concentration which is too high will not be economical, because the polishing speed can not be increased with increase of the concentration.

The metal polishing agent in accordance with the present invention can be easily obtained in a simple manner such that the emulsion polymerization of the vinyl compound is carried out to obtain the aqueous emulsion containing the spherical resin particle, and then the resulting aqueous emulsion is mixed with the complexing agent.

The metal polishing agent of the present invention may additionally contain an oxidizing agent. The oxidizing agent includes, for example, ferric nitrate, ferric chloride, ferric sulfate, aqueous hydrogen peroxide solution, potassium periodate, ammonium persulfate, perchloric acid, and sodium perchlorate.

Polishing of the metal film formed on a silicon wafer can be carried out by the CMP in a well known manner using the metal polishing agent of the present invention.

After the polishing, the remaining resin particles on the metal film, if any, can be easily and completely removed by e.g. an oxygen plasma combustion.

In accordance with the present invention, the metal polishing agent can be produced without the step of dispersing polishing particles in water, the particle size of the polishing agent can be controlled arbitrarily at the time of the emulsion polymerization and the polishing particles in the polishing agent are spherical in shape to exhibit a stable polishing performance without any damage on the surface of the materials to be polished. Moreover, the polishing agent of the present invention can exhibit a polishing speed sufficient for the practical production of semiconductor devices, and after the polishing, the polishing particles remaining on the surface of the polished product, if any, can be easily and completely removed by e.g. combustion because the particles are of resin. Furthermore, there can be obtained a polished product freed from defects such as damages, the dashing and the remaining polishing particles, and therefore decrease of the reliability and product yield caused by the defects can be avoided.

The present invention is illustrated in more detail with reference to the following Example and Comparative Example, which are only illustrative but not limitative.

### Example 1

### Preparation of aqueous emulsion

4g of ammonium lauryl sulfate as an emulsifier, 63 g of ultra pure water, and 100 g of styrene and 4 g of divinylbenzene as a vinyl compound were mixed under stirring to prepare a monomer emulsion.

On the other hand, in a 500 ml volume reactor equipped with a temperature-controller and a stirrer, 0.04 g of ammonium lauryl sulfate and 170 g of ultra pure water were placed and the temperature was raised to 75°C, and then the atmosphere of the reactor was substituted by nitrogen gas. Thereafter, 8.5 g of a 4% by weight aqueous ammonium persulfate solution as a polymerization initiator was supplied into the reactor, and successively the monomer emulsion prepared above was supplied into the reactor over 4 hours at a constant rate, thereby obtaining an aqueous emulsion wherein styrene-divinylbenzene copolymer particles were dispersed.

The concentration of the copolymer particles in the aqueous emulsion was found to be 30.2% by weight. The resin particles were observed microscopically to be spheres having 0.1 µ m of average particle size. There was observed no aggregation of the resin particles.

### Preparation of metal polishing agent

The aqueous emulsion obtained above, ammonium fluoride as a complexing agent and ultra pure water were mixed to obtain a metal polishing agent having the composition as shown in Table 1.

### Polishing of Al film

Using the polishing agent obtained above, polishing of a wafer sputtered with Al was carried out under the following polishing conditions :
Polishing machine : MECAPOL P-200, manufactured by PRESI
Revolution of rotating surface plate : 550 rpm
Revolution of wafer retainer : 75 rpm
Polishing pressure : 240 g/cm²
Flow rate of polishing agent : 55 ml/min.
Polishing time : 1 min.

After the polishing, no damage was observed on the aluminum surface.

### Comparative Example 1

The above Example 1 was repeated, provided that no complexing agent was used for the preparation of the polishing agent.

After the polishing, no damage was observed on the aluminum surface, but the polishing speed was very low as shown in Table 1.

**Table 1**

| | Concentration of resin particle (wt.%) | Concentration of NH₄F (wt.%) | Polishing speed (Å/min.) |
|---|---|---|---|
| Example 1 | 10 | 2 | 2900 |
| Comparative Example 1 | 10 | 0 | 300 |

### Example 2

### Preparation of aqueous emulsion

In a 500 ml volume reactor equipped with a temperature-controller and a stirrer, 320 g of ultra pure water and 3.2 g of ammonium persulfate as a polymerization initiator were placed and the temperature was raised to 80°C, and then the atmosphere of the reactor was substituted by nitrogen gas. Thereafter, 80 g of methyl methacrylate and 4 g of divinylbenzene as a monomer were supplied into the reactor over 4 hours at a constant rate, thereby obtaining an aqueous emulsion wherein methyl methacrylatedivinylbenzene copolymer particles were dispersed.

The concentration of the copolymer particles in the aqueous emulsion was found to be 20.1% by weight. The resin particles were observed microscopically to be spheres having 0.3 µ m of an average particle size. There was observed no aggregation of the resin particles.

### Preparation of metal polishing agent

The aqueous emulsion obtained above, ammonium fluoride as a complexing agent and ultra pure water were mixed to obtain a metal polishing agent having the composition as shown in Table 2.

### Polishing of Al film

Using the polishing agent obtained above, polishing of a wafer sputtered with Al was carried out under the following polishing conditions :
Polishing machine : MECAPOL P-200, manufactured by PRESI
Revolution of rotating surface plate : 550 rpm
Revolution of wafer retainer : 75 rpm
Polishing pressure : 240 g/cm²
Flow rate of polishing agent : 55 ml/min.
Polishing time : 1 min.

After the polishing, no damage was observed on the aluminum surface.

### Comparative Example 2

The above Example 2 was repeated, provided that no complexing agent was used for the preparation of the polishing agent.

After the polishing, no damage was observed on the aluminum surface, but the polishing speed was very low as shown in Table 2.

**Table 2**

| | Concentration of resin particle (wt.%) | Concentration of NH₄F (wt.%) | Polishing speed (Å/min.) |
|---|---|---|---|
| Example 2 | 10 | 2 | 3700 |
| Comparative Example 2 | 10 | 0 | 500 |

### Examples 3-4

### Preparation of metal polishing agent in Example 3

The aqueous emulsion obtained in Example 2, acetylacetone as a complexing agent, hydrogen peroxide and ultra pure water were mixed to obtain a metal polishing agent having the composition as shown in Table 3.

### Preparation of metal polishing agent in Example 4

The aqueous emulsion obtained in Example 2, glycine as a complexing agent, hydrogen peroxide and ultra pure water were mixed to obtain a metal polishing agent having the composition as shown in Table 3.

### Polishing of Cu film

Using the polishing agents obtained above, polishing of a wafer sputtered with Cu was carried out under the following polishing conditions :
Polishing machine : MECAPOL E460, manufactured by PRESI
Revolution of rotating surface plate : 40 rpm
Revolution of wafer retainer : 40 rpm
Polishing pressure : 200 g/cm²
Flow rate of polishing agent : 100 ml/min.
Polishing time : 1 min.

After the polishing, no damage was observed on the copper surface.

### Comparative Examples 3-4

The above Examples 3-4 were repeated, provided that no complexing agent was used for the preparation of the polishing agent.

After the polishing, no damage was observed on the copper surface, but the polishing speed was very low as shown in Table 3

**Table 3**

| | Concentrati on of resin particle (wt.%) | Concentrati on of acetylaceto ne (wt.%) | Concentrati on of glycine (wt.%) | Concentrati on of H₂O₂ (wt.%) | Polishing speed (Å/min.) |
|---|---|---|---|---|---|
| Example 3 | 5 | 1 | 0 | 0.5 | 2250 |
| Example 4 | 5 | 0 | 1 | 1.5 | 6120 |
| Comparative Examples 3-4 | 5 | 0 | 0 | 0.5 | 840 |

## Claims

1. A metal polishing agent comprising an aqueous emulsion comprising a complexing agent capable of reacting with a metal to be polished to form a water soluble metal complex and resin particles prepared by emulsion polymerization of a vinyl compound.

2. A metal polishing agent according to Claim 1, wherein the complexing agent is ammonium fluoride, acetylacetone, citric acid, tartaric acid, glycine, catechol, lysine or 2-aminoethanesulfonic acid.

3. A metal polishing agent according to Claim 1 or 2, wherein the concentration of the complexing agent is from 0.5% to 10% by weight based on the weight of the metal polishing agent.

4. A metal polishing agent according to any one of Claims 1 to 3, wherein the concentration of the resin particles is from 0.5% to 20% by weight based on the weight of the metal polishing agent.

5. A metal polishing agent according to any one of Claims 1 to 4, wherein the average particle size of the resin particles is from 0.05 µ m to 0.5 µ m.

6. A process for producing a metal polishing agent according to any one of Claims 1 to 5, which comprises steps of emulsion-polymerizing a vinyl compound to obtain an aqueous emulsion comprising a resin particle and mixing the aqueous emulsion with a complexing agent capable of reacting with a metal to be polished to form a water soluble metal complex.

7. The process according to Claim 6, wherein the emulsion polymerization is carried out in an aqueous medium in the presence of a polymerization initiator.

8. The process according to Claim 7, wherein the polymerization initiator is potassium persulfate, sodium persulfate, ammonium persulfate, 2,2-azobis(2-amidinopropane)hydrochloride or a redox initiator.

9. The process according to any one of Claims 6 to 8, wherein the concentration of the polymerization initiator is not less than 0.05% by weight based on the weight of the vinyl compound.

10. The process according to any one of Claims 6 to 9, wherein the emulsion polymerization is carried out in the presence or absence of an emulsifier.

11. The process according to any one of Claims 6 to 10, wherein the emulsion polymerization is carried out at a temperature of from 30°C to 100°C.

12. The process according to any one of Claims 6 to 11, wherein the vinyl compound is at least one compound selected from aromatic vinyl compounds, conjugated diene compounds, vinyl halides, ethylene, vinyl esters of mono or dicarboxylic acids or C₁-₁₈ alkyl esters of (meth)acrylic acids.

13. A process for polishing a metal, which comprises polishing the metal by a chemical mechanical polishing with the polishing agent according to any one of Claims 1 to 5.

14. The process according to Claim 13, wherein the metal is a metal film formed on a silicon wafer.

15. A silicon wafer, on which a metal film is formed and polished by the process according to Claim 14.

16. Use of the metal polishing agent according to any one of claims 1 to 5 for polishing a metal film formed on a silicon wafer.
